(19) Europäisches Patentamt / European Patent Office / Office européen des brevets

(11) **EP 2 916 455 A1**

(12) **EUROPÄISCHE PATENTANMELDUNG**

(43) Veröffentlichungstag:
**09.09.2015 Patentblatt 2015/37**

(21) Anmeldenummer: **15155045.6**

(22) Anmeldetag: **13.02.2015**

(51) Int Cl.:
*H02S 50/10* (2014.01)     *H02H 1/00* (2006.01)
*H01L 31/02* (2006.01)     *G01R 31/02* (2006.01)
*G01R 31/40* (2014.01)

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **07.03.2014   DE 102014204253**

(71) Anmelder: **Siemens Aktiengesellschaft**
**80333 München (DE)**

(72) Erfinder:
• **Martel, Jean-Mary**
  **93105 Tegernheim (DE)**
• **Erhard, Felix**
  **98693 Ilmenau (DE)**
• **Festl, Florian**
  **93051 Regensburg (DE)**

(54) **Detektieren eines seriellen Lichtbogens in einer elektrischen Anlage**

(57)     Die Erfindung betrifft eine Einrichtung (36) zum Detektieren eines seriellen Lichtbogens in einer elektrischen Anlage (10), die eine elektrische Gleichspannungsquelle (12) sowie einen an die Gleichspannungsquelle (12) angeschlossenen Wechselrichter (14) umfasst, wobei die Einrichtung (36) eine Überwachungseinheit (32), die eingerichtet ist, in der elektrischen Anlage (10) eine elektrische Spannung auf Spannungsänderungen und einen elektrischen Strom auf Stromänderungen zu überwachen, sowie eine Auswerteeinheit (30) aufweist, die eingerichtet ist, die ermittelten Spannungs- und Stromänderungen zum Detektieren des seriellen Lichtbogens auszuwerten und ein Signal entsprechend eines Ergebnisses des Auswertens zu erzeugen. Erfindungsgemäß umfasst die Einrichtung (36) eine Ermittlungseinheit (26) zum Ermitteln, ob eine spontane Änderung eines aktuellen bestimmungsgemäßen Betriebszustands ($M_{PP}$) vorliegt, bei der sowohl die elektrische Spannung als auch der elektrische Strom reduziert sind, eine Vergleichseinheit (28) zum Vergleichen eines Betrags der Spannungsänderungen und eines Betrags der zu den Spannungsänderungen zeitlich zugeordneten Stromänderungen mit jeweiligen Vergleichswerten sowie Ermitteln von Lichtbogenindikatorwerten basierend auf den Spannungsänderungen und den Stromänderungen bei Überschreiten von wenigstens einem der Vergleichswerte durch die jeweiligen Beträge, eine Prüfeinheit (34) zum Prüfen der Lichtbogenindikatorwerte auf Periodizitäten, und Ausgabeeinheit (22) zum Ausgeben des Signals bei negativem Prüfergebnis.

FIG 1

**Beschreibung**

Die vorliegende Erfindung betrifft eine Einrichtung zum Detektieren eines seriellen Lichtbogens in einer elektrischen Anlage, die eine elektrische Gleichspannungsquelle sowie einen an die Gleichspannungsquelle angeschlossenen Wechselrichter umfasst, wobei die Einrichtung eine Überwachungseinheit, die eingerichtet ist, in der elektrischen Anlage eine elektrische Spannung auf Spannungsänderungen und einen elektrischen Strom auf Stromänderungen zu überwachen, sowie eine Auswerteeinheit aufweist, die eingerichtet ist, die ermittelten Spannungs- und Stromänderungen zum Detektieren eines seriellen Lichtbogens auszuwerten und ein Signal entsprechend eines Ergebnisses des Auswertens zu erzeugen. Darüber hinaus betrifft die Erfindung ein Verfahren zum Detektieren eines seriellen Lichtbogens in einer eine elektrische Gleichspannungsquelle sowie einen an die Gleichspannungsquelle angeschlossenen Wechselrichter umfassenden elektrischen Anlage, zu welchem Zweck in der elektrischen Anlage die elektrische Spannung auf Spannungsänderungen und der elektrische Strom auf Stromänderungen überwacht werden, die detektierten Spannungs- und Stromänderungen zum Detektieren des seriellen Lichtbogens ausgewertet werden und ein Signal entsprechend eines Ergebnisses des Auswertens erzeugt wird.

Lichtbögen sind in elektrischen Anlagen ein Ereignis, das regelmäßig als gestörter Betriebszustand der elektrischen Anlage zu betrachten ist. Sie können gefährliche Zustände zur Folge haben, weshalb es in der Regel üblich ist, entsprechende Einrichtungen zum Detektieren solcher Lichtbögen bei elektrischen Anlagen vorzusehen. Besonders in gleichstrombeaufschlagten elektrischen Anlagen erweisen sich Lichtbögen als gefährlich, da sie aufgrund der vorherrschenden elektrischen Gleichspannung in der Regel nicht selbst verlöschen. Erzeugt der Lichtbogen selbst nicht bereits einen Ausfall der elektrischen Anlage, kann er zumindest gefährliche Folgezustände wie Verursachung von Bränden, insbesondere von Teilen der elektrischen Anlage oder dergleichen, zur Folge haben. Anders als bei wechselspannungsbeaufschlagten elektrischen Anlagen ist bei gleichstrombeaufschlagten elektrischen Anlagen in der Regel keine Selbstverlöschung der Lichtbögen zu erkennen. Der Ermittlung von elektrischen Lichtbögen kommt deshalb gerade bei gleichstrombeaufschlagten elektrischen Anlagen besondere Bedeutung zu.

Der zunehmende Einsatz von regenerativen Energiequellen, insbesondere im Bereich Photovoltaik aber auch im Bereich der Speicherung von elektrischer Energie, führt zu vermehrtem Einsatz von gleichstrombeaufschlagten elektrischen Anlagen, insbesondere auch mit Anlagenteilen, die dem Wettergeschehen ausgesetzt sind. Diese Konstellation begünstigt das Auftreten von Veränderungen der elektrischen Anlage, die Lichtbögen zur Folge haben können.

Dem Grunde nach sind zwei unterschiedliche Arten von Lichtbögen zu unterscheiden, nämlich auf der einen Seite parallele Lichtbögen, die zwischen zwei elektrischen Leitern auftreten, die nicht auf dem gleichen elektrischen Potential liegen, sowie auf der anderen Seite serielle Lichtbögen, die innerhalb einer elektrischen Stromführung auf einem Bezugspotential auftreten. Parallele Lichtbögen sind in der Regel leicht zu erkennen, da ihr Einfluss auf die elektrische Anlage in der Regel so groß ist, dass der aktuelle Betriebszustand sehr deutlich nicht eingehalten werden kann beziehungsweise Sicherungseinrichtungen ausgelöst werden.

Problematisch erweist sich jedoch die Erkennung von seriellen Lichtbögen, die häufig mit den Mitteln der Detektion von parallelen Lichtbögen nicht zuverlässig erkannt werden können. Dies ergibt sich dadurch, dass serielle Lichtbögen unter Umständen den bestimmungsgemäßen Betrieb weiter ermöglichen, zugleich jedoch ihre schädigende Wirkung erst im Laufe der Zeit verbreiten. Beispielsweise kann ein serieller Lichtbogen an einer Kontaktstelle von zwei miteinander verbundenen elektrischen Leitern auftreten, bei denen die Kontaktierung der Verbindung beschädigt ist und ein Stromfluss durch den Lichtbogen hindurch bereitgestellt wird.

Ein Verfahren zum Detektieren von Lichtbögen in photovoltaischen Anlagen offenbart beispielsweise die WO 2013/004 295 A1. Zur Erkennung von seriellen Lichtbögen ist hier vorgesehen, dass die Veränderung einer Leistung eines Arbeitspunktes bei einer fest vorgegebenen Spannung erfolgt. Obwohl sich das Verfahren der WO 2013/004 295 A1 im praktischen Betrieb bewährt hat, treten dennoch Probleme auf.

Wenn unerwartete Änderungen auftreten und die Änderung nicht zuverlässig einer Änderung des angeschlossenen Wechselrichters zugeordnet werden kann, wird ein Lichtbogen detektiert. Diese Technik erfordert es, eine Kommunikation zwischen dem Wechselrichter und der Lichtbogendetektionseinheit vorzusehen. Aus diesem Grund muss der Lichtbogendetektor in den Wechselrichter integriert sein. Dies ist jedoch ein wesentlicher Nachteil bei der Realisierung von Lichtbogendetektoren, die insbesondere serielle Lichtbögen erkennen sollen. Darüber hinaus steht dies einer möglichst flexiblen Erstellung und Gestaltung von elektrischen Anlagen entgegen.

Serielle Lichtbögen treten mit hoher Wahrscheinlichkeit im Falle von Anschlussfehlern oder Anschlussunterbrechungen auf. Wenn solche seriellen Lichtbögen beginnen, können sie über eine sehr lange Zeit andauern, weil die Spannungs-/Stromeigenschaften der elektrischen Energiequelle die Stabilität des Lichtbogens erhöhen. Die mit dem seriellen Lichtbogen erzeugte Energie kann an der schadhaften Stelle, an der der serielle Lichtbogen auftritt, das Zünden brennbarer Materialien verursachen und einen Brand auslösen.

Darüber hinaus ist es bekannt, Gleichstromwerte im Frequenzbereich zu analysieren. Dies nutzt den Effekt, dass Lichtbögen Fluktuationen in ihrer Impedanz zeigen, deren schnelle Änderungen in unterschiedlichen Bereichen des Frequenzbereichs detektiert werden können. Der Frequenzbereich kann von einigen Kilohertz bis einigen Megahertz sein. Dieses Verfahren ist jedoch sehr empfindlich hinsichtlich Störungen sowie Störungen, die durch den Wechselrichter erzeugt werden.

Es ist deshalb die Aufgabe der Erfindung, ein Verfahren sowie eine Einrichtung der gattungsgemäßen Art dahingehend zu verbessern, dass serielle Lichtbögen zuverlässiger erkannt werden können.

Als Lösung schlägt die Erfindung eine Einrichtung gemäß dem unabhängigen Anspruch 1 vor. Verfahrensseitig wird ein Verfahren gemäß dem weiteren unabhängigen Anspruch 2 vorgeschlagen. Weitere Vorteile ergeben sich durch Merkmale der abhängigen Ansprüche.

Mit der Erfindung wird bei einer gattungsgemäßen Einrichtung insbesondere vorgeschlagen, dass die Einrichtung eine Ermittlungseinheit zum Ermitteln, ob eine spontane Änderung eines aktuellen bestimmungsgemäßen Betriebszustands vorliegt, bei der sowohl die elektrische Spannung als auch der elektrische Strom reduziert sind, eine Vergleichseinheit zum Vergleichen eines Betrags der Spannungsänderungen und eines Betrags der zu den Spannungsänderungen zeitlich zugeordneten Stromänderungen mit jeweiligen Vergleichswerten sowie Ermitteln von Lichtbogenindikatorwerten basierend auf den Spannungsänderungen und den Stromänderungen bei Überschreiten von wenigstens einem der Vergleichswerte durch die jeweiligen Beträge, eine Prüfeinheit zum Prüfen der Lichtbogenindikatorwerte auf Periodizitäten sowie eine Ausgabeeinheit zum Ausgeben eines Signals bei negativem Prüfergebnis aufweist.

Verfahrensseitig wird mit der Erfindung insbesondere vorgeschlagen, dass ein gattungsgemäßes Verfahren wenigstens die Schritte umfasst:

- Ermitteln, ob eine spontane Änderung eines aktuellen bestimmungsgemäßen Betriebszustands ($M_{PP}$) vorliegt, bei der sowohl die elektrische Spannung als auch der elektrische Strom reduziert sind,
- Vergleichen eines Betrags der Spannungsänderungen und eines Betrags der zu den Spannungsänderungen zeitlich zugeordneten Stromänderungen mit jeweiligen Vergleichswerten sowie Ermitteln von Lichtbogenindikatorwerten basierend auf den Spannungsänderungen und/oder den Stromänderungen bei Überschreiten von wenigstens einem der Vergleichswerte durch die jeweiligen Beträge,
- Prüfen der Lichtbogenindikatorwerte auf Periodizitäten, und
- Ausgeben des Signals bei negativem Prüfergebnis.

Mit der Erfindung ist es möglich, die Zuverlässigkeit der Detektion von seriellen Lichtbögen deutlich zu verbessern. Das erfindungsgemäße Verfahren nutzt dem Grunde nach drei Kriterien, die sämtlich erfüllt sein müssen, damit auf Vorliegen eines seriellen Lichtbogens erkannt werden kann. Dadurch wird der Einfluss von Störungen jeglicher Art erheblich reduziert, so dass die Zuverlässigkeit der Detektion entsprechend erhöht ist. Insbesondere ist es mit der Erfindung möglich, durch die elektrische Anlage selbst erzeugte Einflüsse beziehungsweise Störungen zu erkennen und für die Betrachtung bei der Detektion der seriellen Lichtbögen außer Acht zu lassen. Die Erfindung verbessert demnach die Möglichkeit einer Unterscheidung zwischen durch serielle Lichtbögen verursachte Einwirkungen und anlagenspezifischen Einwirkungen. Insbesondere trifft dies auf Störungen beziehungsweise Einwirkungen zu, die durch den Wechselrichter erzeugt werden.

Die elektrische Gleichspannungsquelle kann beispielsweise durch ein oder mehrere miteinander verschaltete Photovoltaikmodule gebildet sein. Natürlich kann die Gleichspannungsquelle auch ein elektrischer Energiespeicher, beispielsweise in Form von einem oder mehreren elektrischen Akkumulatoren sein, die entsprechend miteinander verschaltet sind. Darüber hinaus kann die elektrische Gleichspannungsquelle auch durch eine oder mehrere Brennstoffzellen, einem oder mehreren mittels einer Verbrennungskraftmaschine angetriebenen elektrischen Generatoren, einem oder mehreren Windrädern, oder dergleichen sein. Natürlich können die vorgenannten Möglichkeiten für die Gleichspannungsquelle auch miteinander kombiniert sein. Besonders vorteilhaft erweist sich die Erfindung jedoch bei Einsatz von Photovoltaikmodulen.

Ein Wechselrichter ist eine elektrische Einrichtung, die es erlaubt, die durch die elektrische Gleichspannungsquelle bereitgestellte elektrische Energie in eine elektrische Wechselspannung umzuwandeln, vorzugsweise derart, dass sie in ein öffentliches Energieversorgungsnetz eingespeist werden kann. Zu diesem Zweck kann der Wechselrichter einphasig oder auch mehrphasig, insbesondere dreiphasig ausgebildet sein, um eine energietechnische Kopplung an bestehende elektrische Netze, insbesondere Wechselspannungsanlagen ermöglichen zu können.

Heutzutage werden Wechselrichter in Form sogenannter statischer Energiewandler eingesetzt, das heißt, dass sie anders als dynamische Energiewandler keine mechanisch bewegbaren, insbesondere rotierbaren Teile aufweisen. Wechselrichter der gattungsgemäßen Art als statische Energiewandler sind in der Regel als getaktete elektronische Energiewandler ausgebildet, und weisen zu diesem Zweck wenigstens ein Halbbrückenmodul mit zwei in Serie geschalteten Halbleiterschaltern auf, mittels welchem eine mittels eines Zwischenkreises bereitgestellte elektrische Gleichspannung der elektrischen Gleichspannungsquelle in eine elektrische Wechselspannung umgewandelt werden kann.

Ferner ist eine Überwachungseinheit vorgesehen, mittels der die elektrische Spannung der elektrischen Anlage sowie der elektrische Strom in der elektrischen Anlage, vorzugsweise an einem Anschluss des Wechselrichters, auf Änderungen überwacht werden können. Die Überwachungseinheit kann zu diesem Zweck Spannungs- und/oder Stromsensoren aufweisen, mittels denen die elektrische Spannung sowie der elektrische Strom ermittelt werden können. Die Überwachungseinheit detektiert Änderungen der Spannung und/oder des Stroms und stellt die ermittelten Werte der Auswerteeinheit bereit, die basierend auf den bereitgestellten Werten einen seriellen Lichtbogen detektieren kann. Wird ein entsprechender Lichtbogen detektiert, erzeugt die Auswerteeinheit ein entsprechendes Signal, welches ausgegeben wird. Mit diesem Signal kann beispielsweise eine Warneinrichtung oder auch eine Schutzeinrichtung der elektrischen Anlage gesteuert werden. Beispielsweise kann die Schutzeinrichtung elektromechanische Kontakte aufweisen, mittels denen der Energiefluss unterbrochen werden kann, so dass der serielle Lichtbogen keine weiteren Schäden anzurichten vermag. Die Schutzeinrichtung kann durch eine oder mehrere Sicherungen, einem Schütz, Kombinationen hiervon oder dergleichen gebildet sein.

Die Erfindung sieht zu diesem Zweck eine Ermittlungseinheit vor, die eingerichtet ist, zu ermitteln, ob eine spontane Änderung eines aktuellen bestimmungsgemäßen Betriebszustands vorliegt, bei der sowohl die elektrische Spannung als auch der elektrische Strom reduziert sind. Der aktuelle bestimmungsgemäße Betriebszustand ist ein Betriebszustand im ungestörten Betrieb, und kann vorzugsweise durch einen Arbeitspunkt der elektrischen Gleichspannungsquelle gebildet sein. Bei Photovoltaikmodulen ist dies vorzugsweise der Betriebszustand, bei dem die maximale Leistung bereitgestellt wird.

Ein zweites Kriterium sieht vor, dass eine Vergleichseinheit eingerichtet ist, einen Betrag der Spannungsänderungen und einen Betrag der zu den Spannungsänderungen zeitlich zugeordneten Stromänderungen mit jeweiligen Vergleichswerten, das heißt, einem Vergleichswert für die Spannungsänderung und einem Vergleichswert für die Stromänderung, zu vergleichen. Hieraus ermittelt die Vergleichseinheit ferner Lichtbogenindikatorwerte, die auf den Spannungsänderungen und den Stromänderungen bei Überschreiten von wenigstens einem der Vergleichswerte durch die jeweiligen Beträge ermittelt werden. Natürlich kann alternativ auch vorgesehen sein, dass eine Überschreitung von beiden Vergleichswerten, nämlich dem Vergleichswert für die Spannungsänderung und dem Vergleichswert für die Stromänderung, vorliegen muss und hierauf basierend die Lichtbogenindikatorwerte ermittelt werden.

Schließlich ist zum Durchführen eines dritten Kriteriums die Prüfeinheit vorgesehen, die eingerichtet ist, die Lichtbogenindikatorwerte auf Periodizitäten zu prüfen. Damit ist es möglich, Einflüsse außer Acht zu lassen, die durch die elektrische Anlage selbst erzeugt werden, wenn sie im bestimmungsgemäßen Betrieb betrieben wird. Dies kann zum Beispiel eine durch den Wechselrichter bewirkte Rückwirkung sein, die beispielsweise auf einer Taktung von Halbleiterschaltern des Wechselrichters basiert oder dergleichen. Das Prüfergebnis wird an die Ausgabeeinheit übermittelt, die eingerichtet ist, bei negativem Prüfergebnis das Signal auszugeben. Das negative Prüfergebnis entspricht hier also der Tatsache, dass keine Periodizität ermittelt werden konnte. Daraus ergibt sich die positive Detektion des seriellen Lichtbogens.

Das Prüfen auf Periodizitäten kann beispielsweise dadurch realisiert werden, dass geprüft wird, ob Lichtbogenindikatorwerte mit im Wesentlichen festen Zeitabständen auftreten. Darüber hinaus besteht natürlich die Möglichkeit, eine spektrale Analyse durchzuführen, beispielsweise durch Transformation in den Frequenzbereich, zum Beispiel mittels einer FourierTransformation oder dergleichen, wobei bei ausgeprägten Signalausschlägen im Frequenzbereich davon auszugehen ist, dass es sich um periodische Signale handelt. In diesem Fall wird kein serieller Lichtbogen detektiert. Handelt es sich dagegen bei der spektralen Darstellung um ein im Wesentlichen stochastisch verteiltes Signal, ist davon auszugehen, dass ein serieller Lichtbogen vorliegt. In diesem Fall ist das Prüfergebnis auf Periodizitäten negativ und wird entsprechend an die Ausgabeeinheit übermittelt. Die Ausgabeeinheit liefert dann das Signal, welches indikativ für den seriellen Lichtbogen ist.

Mit der Erfindung wird weiterhin vorgeschlagen, dass der Lichtbogenindikatorwert durch Multiplikation einer jeweiligen Spannungsänderung mit einer zeitlich zugeordneten Stromänderung ermittelt wird. Hierdurch lassen sich Störungen, die durch betriebsbedingte Schwankungen des Stromes auftreten können, deutlich reduzieren, so dass sie gut als nicht einem seriellen Lichtbogen zuordbar erkannt werden können.

Gemäß einem weiteren Aspekt der Erfindung wird vorgeschlagen, dass die spontane Änderung des aktuellen bestimmungsgemäßen Betriebszustands zu einem zeitlich zumindest vorübergehenden Betriebszustand führt, der einem Lichtbogenwarnbereich zugeordnet ist. Der Lichtbogenwarnbereich ist ein Bereich, der dem ersten Kriterium zugeordnet ist. Führt die spontane Änderung zu einem vorübergehenden Betriebszustand, der außerhalb des Lichtbogenwarnbereichs ist, ist davon auszugehen, dass kein serieller Lichtbogen vorliegt, sondern eine andere bestimmungsgemäße Änderung in der elektrischen Anlage vorgenommen worden ist.

Nur wenn alle drei Kriterien erfüllt sind, wird ein serieller Lichtbogen detektiert.

Weiterhin wird vorgeschlagen, dass der Lichtbogenwarnbereich eine obere Spannungsgrenze umfasst, die gegenüber der elektrischen Spannung des aktuellen bestimmungsgemäßen Betriebszustands um eine vorgebbare Restspannung reduziert wird. Die vorgebbare Restspannung ist beispielsweise bei elektrischen Anlagen für Photovoltaikmodule als elektrische Gleichspannungsquelle 2 V. Die Spannung kann natürlich abhängig von der elektrischen Anlage und den weiteren von der elektrischen Anlage umfassten Baueinheiten sein und entsprechend angepasst werden.

Weiterhin wird vorgeschlagen, dass der Lichtbogenwarnbereich eine untere Stromgrenze umfasst, die gegenüber dem elektrischen Strom des aktuellen bestimmungsgemäßen Betriebszustands um einen Faktor reduziert wird, der aus einem Verhältnis der um eine Lichtbogenspannung reduzierten elektrischen Spannung des aktuellen bestimmungsgemäßen Betriebszustands zur elektrischen Spannung des aktuellen bestimmungsgemäßen Betriebszustands gebildet wird. Der Lichtbogen bewirkt also einen Faktor, der die obere Stromgrenze definiert. Wird ein Strom oberhalb der Stromgrenze detektiert, ist davon auszugehen, dass es sich nicht um einen seriellen Lichtbogen handelt, der die Veränderung des Betriebszustands bewirkt hat. Entsprechend ist in diesem Fall das erste Kriterium dann nicht erfüllt.

Schließlich wird vorgeschlagen, dass der Lichtbogenwarnbereich eine untere Stromgrenze und eine untere Spannungsgrenze umfasst, die durch eine Impedanz des aktuellen bestimmungsgemäßen Betriebszustands gebildet wird. Bei PhotovoltaikModulen kann dies beispielsweise der Betriebszustand der maximalen Leistung sein. Zusammen mit den beiden zuvor genannten Kriterien für den Lichtbogenwarnbereich wird somit ein geschlossener Bereich bestimmt, der einen Hinweis darauf liefert, dass das erste Kriterium erfüllt ist. Fällt die spontane Änderung des aktuellen Betriebszustands in den Lichtbogenwarnbereich, werden die weiteren Kriterien geprüft. Ansonsten kann die Prüfung bereits an dieser Stelle beendet werden. Spontan ist eine Änderung, wenn sie innerhalb von Mikrosekunden bis einigen Sekunden auftritt.

Gemäß einem weiteren Aspekt der Erfindung wird vorgeschlagen, dass Messwerte der überwachten elektrischen Spannung und/oder des elektrischen Stromes gefiltert werden. Das Filter, das hier zum Einsatz kommen soll, kann an die charakteristischen Eigenschaften eines seriellen Lichtbogens angepasst gewählt sein. Beispielsweise kann vorgesehen sein, dass ein Tiefpass TP zum Herausfiltern von Rauschen vorgesehen ist. Darüber hinaus kann auch ein Hochpass HP vorgesehen sein, mit dem insbesondere langsame periodische anlagenspezifische Signaleinflüsse gefiltert werden können. Dadurch kann die Funktion der die drei Kriterien prüfenden Einheiten verbessert werden. Schließlich wird gemäß einem Aspekt der Erfindung vorgeschlagen, dass ein Überschreiten des Vergleichswerts nur dann erfasst wird, wenn es über eine vorgebbare Zeitspanne erfolgt. Dadurch können zufällige Ereignisse, die mit dem seriellen Lichtbogen nicht in Zusammenhang gebracht werden können, ausgeblendet werden. Beispielsweise kann zu diesem Zweck vorgesehen sein, dass eine Schwellwertüberschreitung zum Beispiel für wenigstens 0,3 Sekunden vorliegen muss. Kürzere Schwellwertüberschreitungen werden anderen Ereignissen als einem seriellen Lichtbogen zugeordnet. Dadurch kann die Durchführung des zweiten Kriteriums weiter verbessert werden.

Weitere Vorteile und Merkmale sind der folgenden Beschreibung eines Ausführungsbeispiels zu entnehmen. In den Figuren bezeichnen gleiche Bezugszeichen gleiche Funktionen und Bauteile.

Es zeigen:

FIG 1 in schematischer Blockschaltbilddarstellung eine elektrische Anlage mit einer Einrichtung gemäß der Erfindung,

FIG 2 in schematischer Darstellung ein Strom-SpannungsDiagramm zur Darstellung von Betriebszuständen,

FIG 3 in schematischer Ansicht ein Strom-Zeit-Diagramm, welches mit einem Graph eine Stromänderung darstellt,

FIG 4 in schematischer Darstellung ein Spannungs-Zeit-Diagramm, welches zeitlich synchronisiert zur FIG 3 mit einem Graphen den Verlauf der Spannung darstellt,

FIG 5 in schematischer Darstellung ein Spannungs-Zeit-Diagramm wie FIG 4, jedoch nach einer Filterung der mit dem Graphen der FIG 4 dargestellten Spannung,

FIG 6 ein Stromänderungs-Zeit-Diagramm in schematischer Darstellung, welches zeitlich synchronisiert zur FIG 3 die momentane Stromänderung mit einem Graphen darstellt,

FIG 7 ein Spannungsänderungs-Zeit-Diagramm in schematischer Darstellung, welches mit einem Graphen die Spannungsänderung der Spannung dargestellt in FIG 4 darstellt und

FIG 8 ein Zeitdiagramm in schematischer Darstellung, welches zeitsynchron zu den vorhergehenden Diagrammen der FIG 3 bis 7 Lichtbogenindikatorwerte mit einem ersten Graphen, wie sie mit einer Vergleichseinheit der Erfindung ermittelt werden, und mit einem zweiten Graphen das Ergebnis einer Signalverarbeitung der Lichtbogenindikatorwerte darstellt.

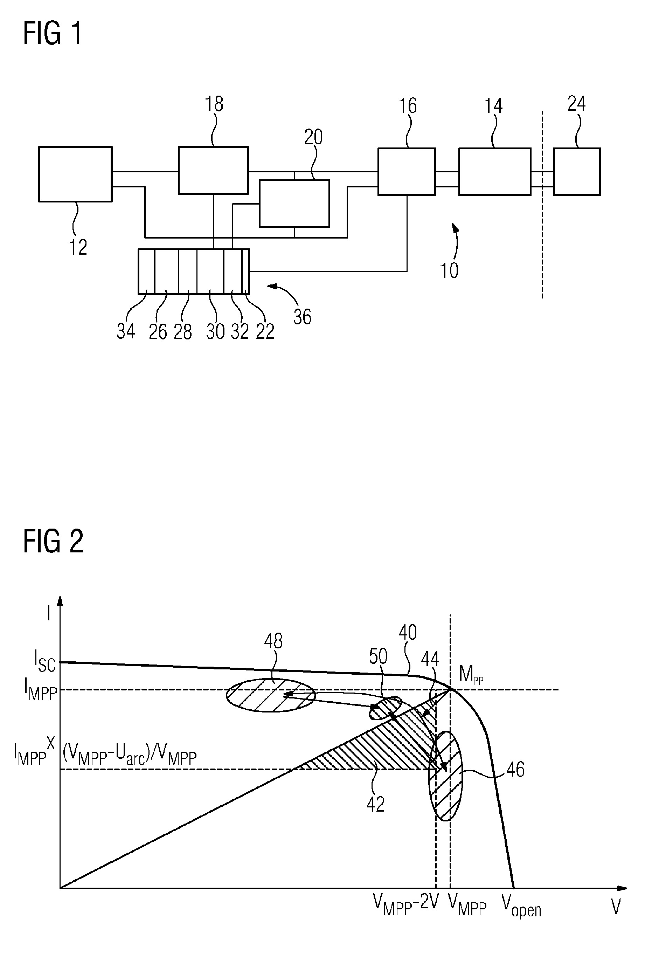

FIG 1 zeigt in einer schematischen Blockschaltbilddarstellung eine elektrische Anlage 10, die eine Anordnung von Photovoltaikmodulen 12 als Gleichspannungsquelle sowie einen über ein Schaltschütz 16 angeschlossenen Wechselrichter 14 umfasst. Die elektrische Anlage 10 weist ferner eine Einrichtung 36 zum Detektieren eines seriellen Lichtbogens in der elektrischen Anlage 10 auf.

Die Einrichtung 36 umfasst eine Überwachungseinheit 32, die eingerichtet ist, in der elektrischen Anlage 10 eine elektrische Spannung mittels eines Spannungssensors 20 auf Spannungsänderungen und einen elektrischen Strom mittels eines Stromsensors 18 auf Stromänderungen zu überwachen. Weiterhin umfasst die Einrichtung 36 eine Auswerteeinheit 30, die eingerichtet ist, die detektierten Spannungs- und Stromänderungen zum Detektieren von seriellen Lichtbögen auszuwerten und mittels einer Ausgabeeinheit 22 ein Signal entsprechend des Ergebnisses des Auswertens zu erzeugen.

Die Einrichtung 36 weist ferner eine Ermittlungseinheit 26 auf, die eingerichtet ist, zu ermitteln, ob eine spontane Änderung eines aktuellen bestimmungsgemäßen Betriebszustands, hier in Bezug auf die Photovoltaikmodule 12, vorliegt, bei der sowohl die elektrische Spannung als auch der elektrische Strom reduziert sind.

Ferner umfasst die Einrichtung 36 eine Vergleichseinheit 28, die eingerichtet ist, einen Betrag der Spannungsänderungen und einen Betrag der zu den Spannungsänderungen zeitlich zugeordneten Stromänderungen mit jeweiligen Vergleichswerten zu vergleichen sowie basierend auf den Spannungsänderungen und den Stromänderungen bei Überschreiten von einem der Vergleichswerte durch die jeweiligen Beträge Lichtbogenindikatorwerte basierend auf den Spannungsänderungen und den Stromänderungen zu ermitteln.

Ferner umfasst die Einrichtung 36 eine Prüfeinheit 34, die eingerichtet ist, die ermittelten Lichtbogenindikatorwerte auf Periodizitäten zu prüfen.

Diese drei Einheiten 26, 28, 36 prüfen drei unterschiedliche Kriterien, wobei ein serieller Lichtbogen dann als erkannt gilt, wenn die ersten beiden Kriterien erfüllt und das letzte Kriterium nicht erfüllt sind.

Mittels der Ausgabeeinheit 22 der Einrichtung 36 kann, sofern die beiden vorhergehenden Kriterien erfüllt sind, bei negativem Prüfergebnis dann ein entsprechendes Signal ausgegeben werden, welches indikativ für einen detektierten seriellen Lichtbogen ist. Dieses Signal dient der Ansteuerung des Schaltschützes 16. Liegt ein detektierter serieller Lichtbogen vor, wird mit dem Signal das Schaltschütz 16 derart gesteuert, dass die elektrische Verbindung zwischen den Photovoltaikmodulen 12 und dem Wechselrichter 14 unterbrochen wird.

FIG 2 zeigt in einer schematischen Diagrammdarstellung eine Spannungs/Strom-Charakteristik der Photovoltaikmodule 12. In Bezug auf einen aktuellen bestimmungsgemäßen Betriebszustand, der mit dem Bezugszeichen $M_{PP}$ bezeichnet ist, lassen sich dem Grunde nach vier Betriebsbereiche definieren. Die Charakteristik der Photovoltaikmodule 12 ist hier mit dem Graphen 40 bezeichnet.

Zu erkennen ist, dass in einem ersten Bereich der Strom ansteigt und die Spannung absinkt. Dies ist der Bereich der Spannungs/Strom-Charakteristik der Photovoltaikmodule 12. Der Betrieb kann in diesem Bereich variieren, und zwar in Abhängigkeit der jeweiligen Last. Die Last ist durch den Wechselrichter 14 gebildet, der entsprechend der angeforderten elektrischen Energie seine Wechselrichtungsfunktion vornimmt.

In einem zweiten Bereich, der rechts oberhalb des aktuellen Betriebszustands $M_{PP}$ liegt, steigen Strom und Spannung gemeinsam an. Dieser Bereich ist einer steigenden Sonneneinstrahlung auf die Photovoltaikmodule 12 zuzuordnen. Ein bewegen des Betriebszustands in diesen Bereich hinein kann lediglich langsam erfolgen.

Ein dritter Bereich, der in dem Diagramm gemäß FIG 2 rechts vom aktuellen Betriebszustand $M_{PP}$ angeordnet ist, beschreibt ein Ansteigen der Spannung bei reduziertem Strom bis zur Leerlaufspannung $V_{open}$, wenn die Stromentnahme 0 ist.

Der vierte Bereich betrifft eine gleichzeitige Strom- und Spannungsabnahme. In diesen Bereich verlagert sich der Betriebszustand, wenn die Sonneneinstrahlung abnimmt oder eben auch bei seriellen Lichtbögen.

Sobald der Strom und die Spannung zugleich abnehmen, muss nun damit gerechnet werden, dass ein serieller Lichtbogen in der elektrischen Anlage 10 vorhanden ist. Eine bekannte Lastimpedanz Z(0) vor Auftreten eines möglichen Lichtbogens ergibt sich wie folgt:

$$Z(0) = \frac{U_{inv}(0)}{I_{inv}(0)} = \frac{U_{Mpp}}{I_{Mpp}}$$

Da ein angenommener serieller Lichtbogen in Serie zwischen den Photovoltaikmodulen 12 und dem Wechselrichter 14 angeordnet ist, kann angenommen werden, dass sich ein Strom $I_{inv}(t)$ und eine Spannung $U_{inv}(t)$ gemessen am Eingang des Wechselrichters 14 unmittelbar nach Zündung des seriellen Lichtbogens wie folgt ergibt:

$$I_{inv}(t) \geq \frac{U_{inv}(0) - U_{arc}}{Z(0)} \qquad U_{inv}(t) < U_{inv}(0) - \Delta U_{min} \qquad U_{inv}(t) \geq I_{inv}(t) \cdot Z(0)$$

Diese drei Gleichungen beschreiben einen begrenzten Bereich, der im Rahmen dieser Anmeldung auch Lichtbogenwarnbereich genannt wird. Der Lichtbogenwarnbereich umfasst eine obere Spannungsgrenze, die gegenüber der elektrischen Spannung des aktuellen bestimmungsgemäßen Betriebszustands $M_{PP}$ um eine vorgebbare Restspannung, hier 2 V, reduziert wird. Darüber hinaus umfasst der Lichtbogenwarnbereich eine untere Stromgrenze, die gegenüber dem elektrischen Strom des aktuellen bestimmungsgemäßen Betriebszustands um einen Faktor reduziert wird, der aus einem Verhältnis der um eine Lichtbogenspannung reduzierten elektrischen Spannung des aktuellen bestimmungsgemäßen Betriebszustands $M_{PP}$ zur elektrischen Spannung des aktuellen Betriebszustands $M_{PP}$ gebildet wird. Schließlich umfasst der Lichtbogenwarnbereich eine obere Stromgrenze und eine untere Spannungsgrenze, die durch die Impedanz $Z(0)$ des aktuellen bestimmungsgemäßen Betriebszustands $M_{PP}$ gebildet wird.

Der Lichtbogenwarnbereich ist in der FIG 2 mit dem Bezugszeichen 42 bezeichnet.

Die Werte für die Lichtbogenspannung $U_{arc}$ und $\Delta U_{min}$ sind Variablen, die experimentell bestimmt werden. $U_{inv}$ ist die Spannung am Wechselrichter 14 und $I_{inv}$ ist der Strom durch den Wechselrichter 14.

Zum Zeitpunkt der Zündung des seriellen Lichtbogens wird angenommen, dass die Lichtbogenspannung größer als 13 V bei Kupferleitern ist. Ein Ansetzen des Wertes für die Lichtbogenspannung $U_{arc}$ von 20 V ist in diesem Fall angemessen. Wäre der Wechselrichter 14 eine resistive Last, würde sich die Spannungsänderung $\Delta U$ am Wechselrichter 14 im Bereich der Lichtbogenspannung $U_{arc}$ bewegen. Die realen Werte sind jedoch immer im Wesentlichen kleiner, weil der Wechselrichter 14 eine aktive Last mit einem Energiespeicher darstellt. Die elektrische Spannung des Energiespeichers verhindert hohe Schwankungen der Eingangsspannung des Wechselrichters 14. Deshalb wird ein kleiner Vergleichswert für die Detektion benutzt, der bei $\Delta U_{min}$ = 2 V liegt.

Die Veränderung des aktuellen Betriebszustands $M_{PP}$ in den vorgeschriebenen Lichtbogenwarnbereich 42 tritt sehr schnell auf, hier innerhalb weniger Millisekunden, wenn der Lichtbogen zündet. Daraus ergeben sich hinsichtlich des Betrags große Änderungen dI/dt und dU/dt. Die schnellen Änderungen der Spannung und des Stroms in den vorgenannten Bereich bilden das erste Kriterium, um serielle Lichtbögen zu detektieren.

Die schnelle Änderung des aktuellen Betriebszustands $M_{PP}$ bei Auftreten eines seriellen Lichtbogens in den Lichtbogenwarnbereich 42 ist mit dem Bezugszeichen 44 gekennzeichnet.

Steht der serielle Lichtbogen länger an, wandert der aktuelle Betriebszustand zunächst entweder in einen Bereich 46 oder in einen Bereich 48 und von dort aus in beiden Fällen schließlich hin zu einem Bereich 50.

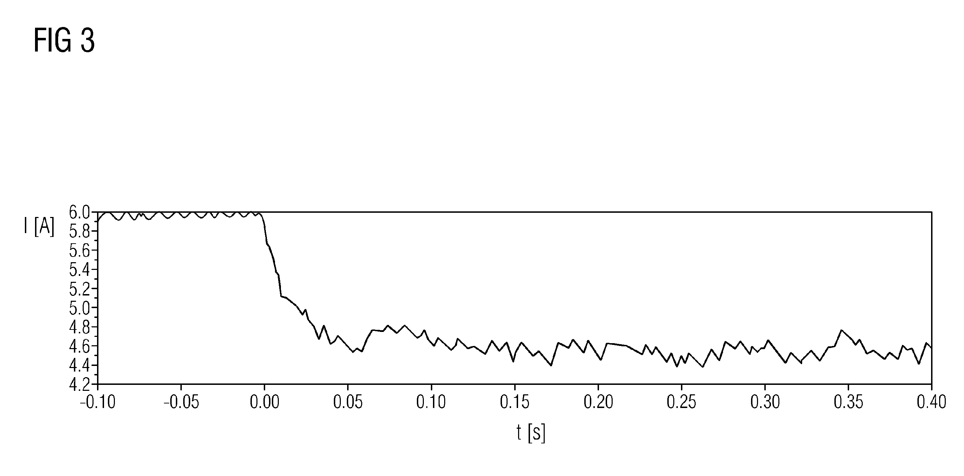

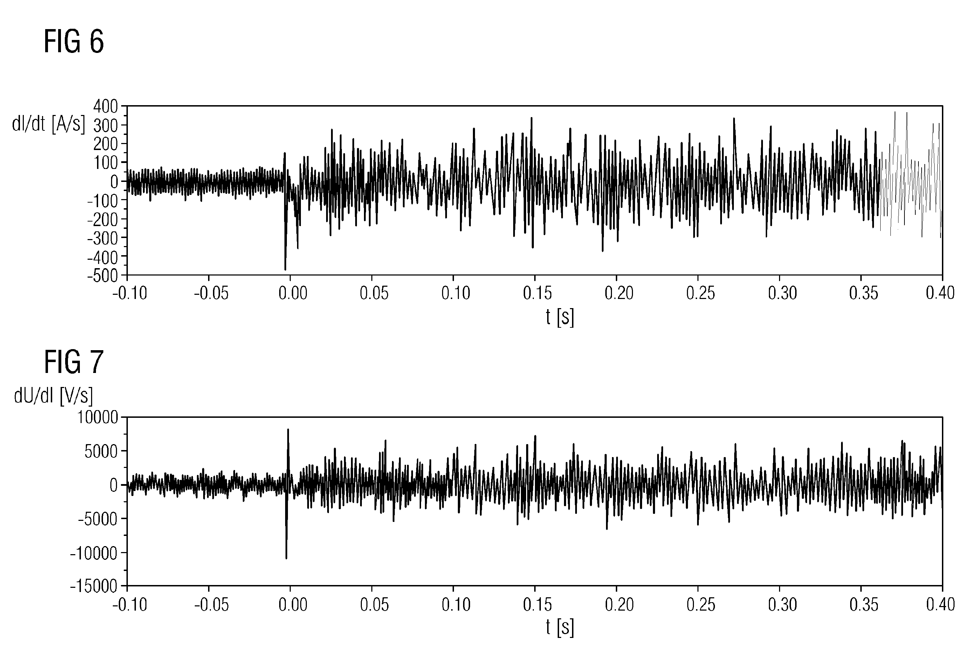

FIG 3 zeigt in einem Strom-Zeit-Diagramm Werte für den elektrischen Strom während der Zündung eines seriellen Lichtbogens. Das schnelle Absinken des Stromes ist mit dem Graphen im Diagramm der FIG 3 zu erkennen. Eine entsprechende differenzielle Darstellung ergibt sich aus dem Diagramm gemäß FIG 6, aus dem ersichtlich ist, dass starke Ausschläge im Bereich des Stromabfalls gemäß FIG 3 auftreten.

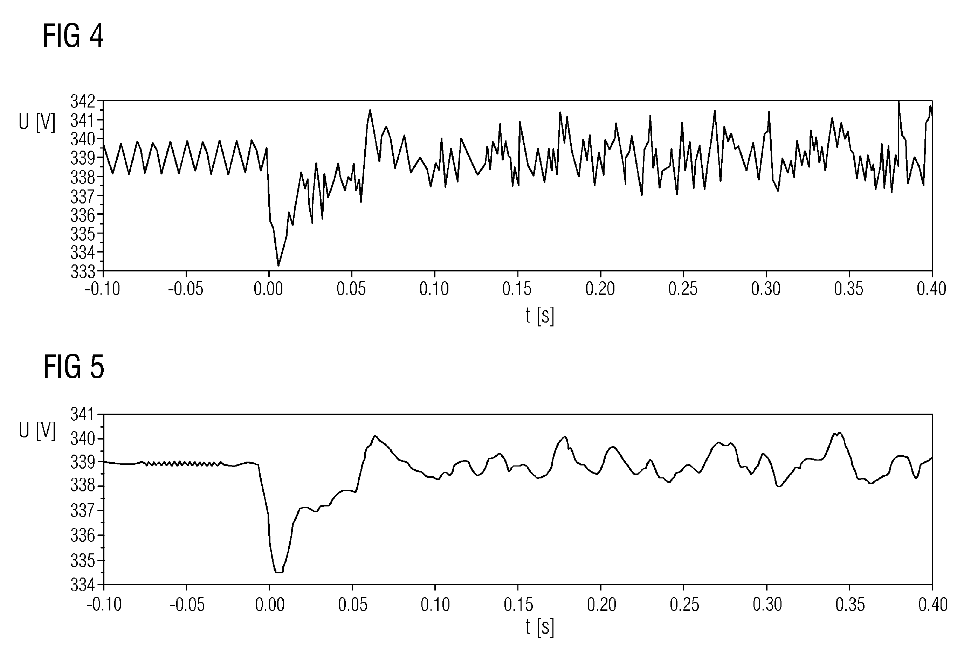

Bezüglich der elektrischen Spannung ist dies entsprechend anhand der FIG 4, 5 und 7 dargestellt. Die FIG 4 zeigt einen entsprechenden Spannungsverlauf, der einer Filterung unterzogen wird, und zu dem in FIG 5 dargestellten Signalverlauf führt. Eine entsprechende differenzielle Darstellung ergibt sich in FIG 7, wobei auch hier ersichtlich ist, dass die auftretenden Spannungsänderungen zu entsprechenden Ausschlägen in der differenziellen Darstellung gemäß FIG 7 führen.

Eine schnelle Abschattung der Photovoltaikmodule 12, beispielsweise durch fliegende Objekte, Rotorblätter einer Windmühle, Wolken oder dergleichen, kann ebenso die vorgenannten Änderungen zur Folge haben. Deshalb sind ergänzende Kriterien erforderlich, reale serielle Lichtbögen von solchen störenden Ereignissen zu unterscheiden.

Es wird angenommen, dass der Wechselrichter 14 im Mittel die Last einstellt, um die vorhergehende Spannung $U_{inv}(0)$ oder den vorhergehenden Strom $I_{inv}(0)$ vor Eintreten des Ereignisses einzustellen, abhängig davon, ob der Wechselrichter 14 spannungs- oder stromgeregelt ist. Über lange Sicht versucht der Wechselrichter 14 einen neuen Betriebszustand zu finden, um den Leistungspegel optimieren zu können. Diese erwarteten Variationen stehen immer in Übereinstimmung mit der Spannungs/Strom-Charakteristik der Photovoltaikmodule 12. Das heißt, dass eine Stromänderung in eine Richtung eine Spannungsänderung in die entgegengesetzte Richtung zur Folge hat.

Im Falle des seriellen Lichtbogens ändert sich die Impedanz und Leistungsänderungen aufgrund des seriellen Lichtbogens befolgen nicht die Spannungs/Strom-Charakteristik der Photovoltaikmodule 12 und weichen signifikant von entsprechend erwarteten Änderungen ab. Diesbezüglich wird auf die obigen Ausführungen zur FIG 1 ergänzend verwiesen.

Bezüglich Abschattung können einzelne Ereignisse oder sich wiederholende Ereignisse mit niedriger Frequenz auftreten. Bei seriellen Lichtbögen sind dagegen diese Änderungen sehr schnell, kontinuierlich und unregelmäßig. Hieraus ergibt sich ein zweites Detektionskriterium, das ebenfalls erfüllt sein muss, wenn ein serieller Lichtbogen positiv detektiert sein soll. Hierfür kann die folgende Gleichung in Betracht gezogen werden:

$$P_{noise}^{arc} = \frac{dU_{inv}(t)}{dt} \cdot \frac{dI_{inv}(t)}{dt} \, sonst \quad P_{noise}^{arc} = 0$$

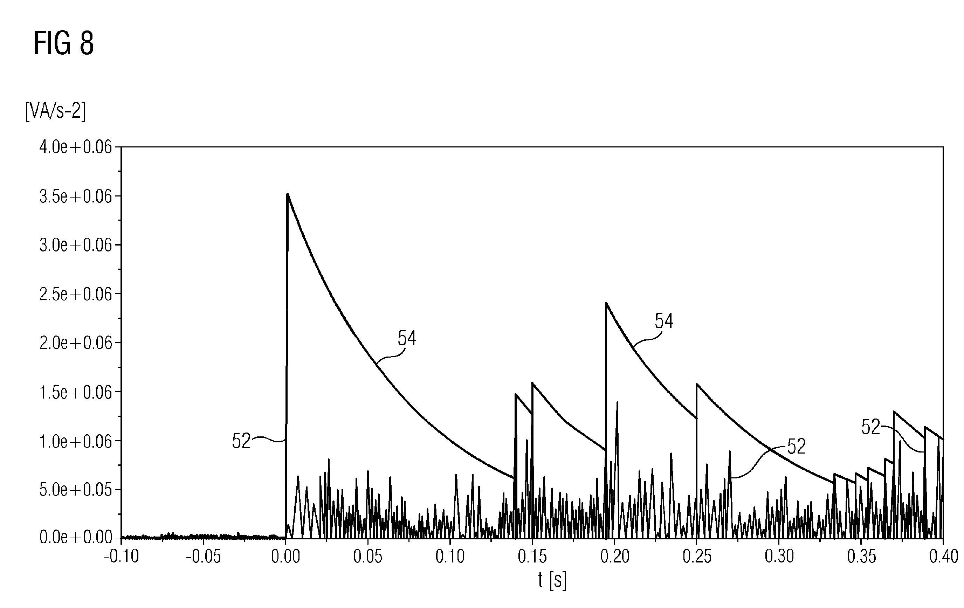

Wie aus den Gleichungen ersichtlich ist, wird ein Lichtbogenindikatorwert ermittelt, der sich aus einem Produkt ergibt, welches aus den Differenzialen der Beträge der Spannungsänderung und der Stromänderung ergibt. Die sich hieraus ergebenden Lichtbogenindikatorwerte $P_{noise}^{arc}$ sind in FIG 8 mit dem Bezugszeichen 52 bezeichnet. Sie repräsentieren die Leistung der elektrischen Änderungen, die nicht mit der Spannungs/Strom-Charakteristik der Photovoltaikmodule 12 in Zusammenhang gebracht werden können. Auf diese Lichtbogenindikatorwerte wird eine mathematische Integration sowie eine weitere Signalverarbeitung angewendet, die als Ausgangssignal einen Signalverlauf ergibt, wie er in FIG 8 anhand des Graphen mit dem Bezugszeichen 54 dargestellt ist. Dieses Signal wird dann mit einem Vergleichswert verglichen. Beispielsweise sind der Vergleichswert für dI/dt 100 A/s und der Vergleichswert für dU/dt 1000 V/s gewählt. Diese Werte können je nach praktischer Ausgestaltung der elektrischen Anlage 10 angepasst sein.

Das mit dem Graphen 54 in FIG 8 dargestellte Signal kann als zweites Kriterium für die Lichtbogendetektion dienen, welches zur positiven Detektion eines seriellen Lichtbogens erfüllt sein muss.

Der Fehlervergleichswert steigt schnell an, wenn die Lichtbogenindikatorwerte $P^{arc}_{noise}$ über einem vorgegebenen Vergleichswert von zum Beispiel 250 000 VAs⁻² liegen und sehr langsam abnehmen, wenn es darunter ist. Wenn die Fehlerreferenz oberhalb eines weiteren Vergleichswerts von zum Beispiel 400 000 VAs⁻² für eine minimale Zeit von zum Beispiel 0,3 s verbleibt, wird das zweite Kriterium als erfüllt betrachtet.

Zusätzlich ist gemäß der Erfindung eine Prüfung eines dritten Kriteriums vorgesehen, nämlich die Prüfung dahingehend, ob die Lichtbogenindikatorwerte $P^{arc}_{noise}$ Periodizitäten aufweisen. Der Zeitabstand zwischen jeder signifikanten Spitze, zum Beispiel überschreiten eines Vergleichswerts von 500 000 VAs⁻², kann gemessen werden und die Varianz soll nicht kleiner als ein weiterer Vergleichswert sein. Alternativ oder ergänzend kann auch eine Analyse im Frequenzbereich erfolgen, insbesondere in einem Frequenzbereich bis zu einigen kHz. Für eine positive Detektion eines seriellen Lichtbogens sollte sich im Frequenzspektrum keine signifikante Spitze finden lassen. Die Nicht-Periodizität der Lichtbogenindikatorwerte bildet das dritte Kriterium, weil angenommen wird, dass Impedanzänderungen basierend auf seriellen Lichtbögen zufällig über lange Zeit erfolgen.

Wenn alle drei Kriterien erfüllt sind, ist ein serieller Lichtbogen zuverlässig erkannt und es wird mittels der Ausgabeeinheit 22 ein Signal ausgegeben, welches das Schaltschütz 16 zum Öffnen seiner Kontakte ansteuert.

Die Vergleichswerte beziehungsweise die minimalen Zeitendauern sowie Vergleichswerte hierfür können eine Funktion der Spannungsänderungen oder Stromänderungen sein. Bei großen Spannungs- und/oder Stromänderungen kann von einer großen Lichtbogenleistung ausgegangen werden und eine Reaktionszeit für den Lichtbogendetektor sollte schnell erfolgen.

Die Detektion serieller Lichtbögen gemäß der Erfindung basiert auf der Analyse von Spannungs- und Stromänderungen, welche als "konform" oder "nicht konform" entsprechend der Spannungs/Strom-Charakteristik der Gleichspannungsquelle 12 klassifiziert sind. Die nicht konformen Ereignisse können durch Leistungsschwankungen der Gleichspannungsquelle 12, hier Photovoltaikmodule, erzeugt werden, beispielsweise indem die Photovoltaikmodule 12 abgeschattet werden oder eben durch Verluste aufgrund von Lichtbögen. Eine Unterscheidung zwischen Abschattung oder externen Störungen wird erreicht mit der Analyse der schnellen Änderungen. Dadurch erlaubt es die Erfindung, eine zuverlässige Detektion von seriellen Lichtbögen sowie deren Stärke gegenüber Störungen zu ermöglichen.

Das vorgenannte Ausführungsbeispiel dient lediglich der Erläuterung der Erfindung und ist für diese nicht beschränkend. Natürlich können Vergleichswerte sowie auch Zeitabstände in erforderlicher Weise angepasst werden um die gewünschte Lichtbogendetektion zu ermöglichen, insbesondere unter Berücksichtigung von anlagenspezifischen Besonderheiten der elektrischen Anlage.

Schließlich können natürlich Merkmale der Ansprüche und der Beschreibung in nahezu beliebiger Weise miteinander kombiniert werden, um zu weiteren Ausgestaltungen im Sinne der Erfindung zu gelangen. Insbesondere können Vorrichtungsmerkmale auch durch entsprechende Verfahrensschritte und umgekehrt realisiert sein.

Bezugszeichenliste

| | |
|---|---|
| 10 | elektrische Anlage |
| 12 | Gleichspannungsquelle |
| 14 | Wechselrichter |
| 16 | Schaltschütz |
| 18 | Stromsensor |
| 20 | Spannungssensor |
| 22 | Ausgabeeinheit |
| 26 | Ermittlungseinheit |
| 28 | Vergleichseinheit |
| 30 | Auswerteeinheit |
| 32 | Überwachungseinheit |

| 34 | Prüfeinheit |
| 36 | Einrichtung |
| 40 | Graph |
| 42 | Lichtbogenwarnbereich |
| 44 | Graph |
| 46, 48, 50 | Bereiche |
| 52, 54 | Graph |

**Patentansprüche**

1. Einrichtung (36) zum Detektieren eines seriellen Lichtbogens in einer elektrischen Anlage (10), die eine elektrische Gleichspannungsquelle (12) sowie einen an die Gleichspannungsquelle (12) angeschlossenen Wechselrichter (14) umfasst, wobei die Einrichtung (36) eine Überwachungseinheit (32), die eingerichtet ist, in der elektrischen Anlage (10) eine elektrische Spannung auf Spannungsänderungen und/oder einen elektrischen Strom auf Stromänderungen zu überwachen, sowie eine Auswerteeinheit (30) aufweist, die eingerichtet ist, die ermittelten Spannungs- und Stromänderungen zum Detektieren des seriellen Lichtbogens auszuwerten und ein Signal entsprechend eines Ergebnisses des Auswertens zu erzeugen,
**gekennzeichnet durch**
eine Ermittlungseinheit (26) zum Ermitteln, ob eine spontane Änderung eines aktuellen bestimmungsgemäßen Betriebszustands ($M_{PP}$) vorliegt, bei der sowohl die elektrische Spannung als auch der elektrische Strom reduziert sind, eine Vergleichseinheit (28) zum Vergleichen eines Betrags der Spannungsänderungen und eines Betrags der zu den Spannungsänderungen zeitlich zugeordneten Stromänderungen mit jeweiligen Vergleichswerten sowie Ermitteln von Lichtbogenindikatorwerten basierend auf den Spannungsänderungen und den Stromänderungen bei Überschreiten von wenigstens einem der Vergleichswerte **durch** die jeweiligen Beträge, eine Prüfeinheit (34) zum Prüfen der Lichtbogenindikatorwerte auf Periodizitäten, und eine Ausgabeeinheit (22) zum Ausgeben des Signals bei negativem Prüfergebnis.

2. Verfahren zum Detektieren eines seriellen Lichtbogens in einer eine elektrische Gleichspannungsquelle (12) sowie einen an die Gleichspannungsquelle angeschlossenen Wechselrichter (14) umfassenden elektrischen Anlage (10), zu welchem Zweck in der elektrischen Anlage (10) die elektrischen Spannung auf Spannungsänderungen und der elektrische Strom auf Stromänderungen überwacht werden, die ermittelten Spannungs- und Stromänderungen zum Detektieren des seriellen Lichtbogens ausgewertet werden und ein Signal entsprechend eines Ergebnisses des Auswertens erzeugt wird,
**dadurch gekennzeichnet,**
**dass** das Auswerten wenigstens die Schritte umfasst:

- Ermitteln, ob eine spontane Änderung eines aktuellen bestimmungsgemäßen Betriebszustands ($M_{PP}$) vorliegt, bei der sowohl die elektrische Spannung als auch der elektrische Strom reduziert sind,
- Vergleichen eines Betrags der Spannungsänderungen und eines Betrags der zu den Spannungsänderungen zeitlich zugeordneten Stromänderungen mit jeweiligen Vergleichswerten sowie Ermitteln von Lichtbogenindikatorwerten basierend auf den Spannungsänderungen und den Stromänderungen bei Überschreiten von wenigstens einem der Vergleichswerte durch die jeweiligen Beträge,
- Prüfen der Lichtbogenindikatorwerte auf Periodizitäten, und Ausgeben des Signals bei negativem Prüfergebnis.

3. Verfahren nach Anspruch 2, **dadurch gekennzeichnet, dass** der Lichtbogenindikatorwert durch Multiplikation einer jeweiligen Spannungsänderung mit einer zeitlich zugeordneten Stromänderung ermittelt wird.

4. Verfahren nach Anspruch 2 oder 3, **dadurch gekennzeichnet, dass** die spontane Änderung des aktuellen bestimmungsgemäßen Betriebszustands ($M_{PP}$) zu einem zeitlich zumindest vorübergehenden Betriebszustand führt, der einem Lichtbogenwarnbereich (42) zugeordnet ist.

5. Verfahren nach Anspruch 4, **dadurch gekennzeichnet, dass** der Lichtbogenwarnbereich (42) eine obere Spannungsgrenze umfasst, die gegenüber der elektrischen Spannung des aktuellen bestimmungsgemäßen Betriebszustands ($M_{PP}$) um eine vorgebbare Restspannung reduziert wird.

6. Verfahren nach Anspruch 4 oder 5, **dadurch gekennzeichnet, dass** der Lichtbogenwarnbereich (42) eine untere Stromgrenze umfasst, die gegenüber dem elektrischen Strom des aktuellen bestimmungsgemäßen Betriebszustands ($M_{PP}$) um einen Faktor reduziert wird, der aus einem Verhältnis der um eine Lichtbogenspannung reduzierten elektrischen Spannung des aktuellen bestimmungsgemäßen Betriebszustands ($M_{PP}$) zur elektrischen Spannung des aktuellen bestimmungsgemäßen Betriebszustands ($M_{PP}$) gebildet wird.

7. Verfahren nach einem der Ansprüche 4 bis 6, **dadurch gekennzeichnet, dass** der Lichtbogenwarnbereich (42) eine untere Stromgrenze und eine untere Spannungsgrenze umfasst, die durch eine Impedanz des aktuellen bestimmungsgemäßen Betriebszustands ($M_{PP}$) gebildet wird.

8. Verfahren nach einem der Ansprüche 2 bis 7, **dadurch gekennzeichnet, dass** Messwerte der überwachten elektrischen Spannung und/oder des elektrischen Stromes gefiltert werden.

9. Verfahren nach einem der Ansprüche 2 bis 8, **dadurch gekennzeichnet, dass** ein Überschreiten des Vergleichswerts nur dann erfasst wird, wenn es über eine vorgegebene Zeitspanne erfolgt.

FIG 1

FIG 2

EP 2 916 455 A1

FIG 3

FIG 4

FIG 5

FIG 6

FIG 7

FIG 8

[VA/s-2]

EP 2 916 455 A1

Europäisches Patentamt
European Patent Office
Office européen des brevets

**EUROPÄISCHER RECHERCHENBERICHT**

Nummer der Anmeldung

EP 15 15 5045

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 8 576 520 B2 (PAMER ANDREAS [AT] ET AL) 5. November 2013 (2013-11-05) * Spalte 3, Zeile 1 - Spalte 6, Zeile 56; Anspruch 11; Abbildungen 1-6 * | 1,2 | INV. H02S50/10 H02H1/00 H01L31/02 |
| A,D | WO 2013/004295 A1 (SMA SOLAR TECHNOLOGY AG [DE]; BEHRENDS HOLGER [DE]; BIENIEK SEBASTIAN) 10. Januar 2013 (2013-01-10) * das ganze Dokument * | 1,2 | ADD. G01R31/02 G01R31/40 |
| A | DE 10 2011 008140 A1 (ELLENBERGER & POENSGEN [DE]) 1. März 2012 (2012-03-01) * Zusammenfassung; Abbildungen 1,2 * | 1,2 | |
| A | JAY JOHNSON ET AL: "Differentiating series and parallel photovoltaic arc-faults", PHOTOVOLTAIC SPECIALISTS CONFERENCE (PVSC), 2012 38TH IEEE, IEEE, 3. Juni 2012 (2012-06-03), Seiten 720-726, XP032257926, DOI: 10.1109/PVSC.2012.6317708 ISBN: 978-1-4673-0064-3 * das ganze Dokument * | 1,2 | |
| A | ERHARD FELIX ET AL: "Measurements of DC arc faults in real photovoltaic systems", 2013 48TH INTERNATIONAL UNIVERSITIES' POWER ENGINEERING CONFERENCE (UPEC), IEEE, 2. September 2013 (2013-09-02), Seiten 1-6, XP032778012, DOI: 10.1109/UPEC.2013.6715040 [gefunden am 2014-01-16] * das ganze Dokument * | 1,2 | |

RECHERCHIERTE SACHGEBIETE (IPC)

H02S
H02H
H01L
G01R

-/--

Der vorliegende Recherchenbericht wurde für alle Patentansprüche erstellt

| Recherchenort | Abschlußdatum der Recherche | Prüfer |
|---|---|---|
| München | 31. Juli 2015 | Hijazi, Ali |

EPO FORM 1503 03.82 (P04C03)

Europäisches
Patentamt

European
Patent Office

Office européen
des brevets

**EUROPÄISCHER RECHERCHENBERICHT**

Nummer der Anmeldung

EP 15 15 5045

| | **EINSCHLÄGIGE DOKUMENTE** | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (IPC) |
| A | YUVENTI JUMIE: "Electric arc-flash energy calculations for photovoltaic systems", 2012 IEEE 38TH PHOTOVOLTAIC SPECIALISTS CONFERENCE (PVSC) PART 2, IEEE, 3. Juni 2012 (2012-06-03), Seiten 1-6, XP032521111, DOI: 10.1109/PVSC-VOL 2.2013.6656698 [gefunden am 2013-11-05] * das ganze Dokument * ----- | 1,2 | |
| | | | RECHERCHIERTE SACHGEBIETE (IPC) |

Der vorliegende Recherchenbericht wurde für alle Patentansprüche erstellt

| Recherchenort | Abschlußdatum der Recherche | Prüfer |
|---|---|---|
| München | 31. Juli 2015 | Hijazi, Ali |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
.......................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 15 15 5045

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

31-07-2015

| Im Recherchenbericht angeführtes Patentdokument | Datum der Veröffentlichung | Mitglied(er) der Patentfamilie | Datum der Veröffentlichung |
|---|---|---|---|
| US 8576520 B2 | 05-11-2013 | AT 509251 A1 | 15-07-2011 |
| | | AU 2010282204 A1 | 01-03-2012 |
| | | CN 102472789 A | 23-05-2012 |
| | | EP 2464986 A1 | 20-06-2012 |
| | | JP 5393891 B2 | 22-01-2014 |
| | | JP 2013502054 A | 17-01-2013 |
| | | KR 20120066636 A | 22-06-2012 |
| | | US 2012134058 A1 | 31-05-2012 |
| | | WO 2011017721 A1 | 17-02-2011 |
| WO 2013004295 A1 | 10-01-2013 | CN 103597363 A | 19-02-2014 |
| | | EP 2729821 A1 | 14-05-2014 |
| | | US 2014119072 A1 | 01-05-2014 |
| | | WO 2013004295 A1 | 10-01-2013 |
| DE 102011008140 A1 | 01-03-2012 | AU 2011297965 A1 | 07-02-2013 |
| | | CA 2809895 A1 | 08-03-2012 |
| | | CN 103155325 A | 12-06-2013 |
| | | DE 102011008140 A1 | 01-03-2012 |
| | | EP 2612410 A1 | 10-07-2013 |
| | | JP 5530566 B2 | 25-06-2014 |
| | | JP 2013542699 A | 21-11-2013 |
| | | KR 20130081697 A | 17-07-2013 |
| | | SG 187202 A1 | 28-02-2013 |
| | | US 2013170084 A1 | 04-07-2013 |
| | | WO 2012028247 A1 | 08-03-2012 |

EPO FORM P0461

Für nähere Einzelheiten zu diesem Anhang : siehe Amtsblatt des Europäischen Patentamts, Nr.12/82

**EP 2 916 455 A1**

**IN DER BESCHREIBUNG AUFGEFÜHRTE DOKUMENTE**

**In der Beschreibung aufgeführte Patentdokumente**

*   WO 2013004295 A1